# FASCICULE DE BREVET EUROPEEN

(11) **EP 2 260 336 B1**
(45) Date de publication et mention de la délivrance du brevet: **06.05.2015**
(21) Numéro de dépôt: 09728513.4
(22) Date de dépôt: 03.04.2009
(51) Int. Cl.: G02B 1/06, G03F 7/00, G02F 1/167, G02F 1/133

(54) **PROCÉDÉ DE RÉALISATION DE CAVITÉS MICRONIQUES OU SUBMICRONIQUES**
VERFAHREN ZUR HERSTELLUNG VON MIKRON- ODER SUBMIKRONKAVITÄTEN
METHOD OF MAKING MICRON OR SUBMICRON CAVITIES

(30) Priorité: 04.04.2008 FR 0852256
(43) Date de publication de la demande: 15.12.2010
(73) Titulaire: Commissariat à l'Énergie Atomique et aux Énergies Alternatives, 75015 Paris (FR)
(72) Inventeur: CAPLET, Stéphane, F-38360 Sassenage (FR); VENIN, Claude, F-38500 Coublevie (FR)
(74) Mandataire: Ilgart, Jean-Christophe
(86) Numéro de dépôt international: PCT/EP2009/053994
(87) Numéro de publication internationale: WO 2009/121950

(56) Documents cités:
- WO-A-02/065215
- FR-A- 2 888 948
- GB-A- 2 435 717
- US-A- 6 063 653
- US-A1- 2004 165 252
- US-A1- 2006 006 336
- US-A1- 2006 275 711
- US-B1- 6 958 207

## Description

### DOMAINE TECHNIQUE ET ART ANTERIEUR

L'invention se rapporte à la réalisation de dispositifs contenant des cavités de dimensions microniques voire submicroniques délimitées par des parois, dans lesquelles un matériau tel qu'un fluide fonctionnel peut être introduit. Une application particulière concerne notamment les dispositifs « optiques » pour lesquels le fluide fonctionnel possède des qualités optiques spécifiques.

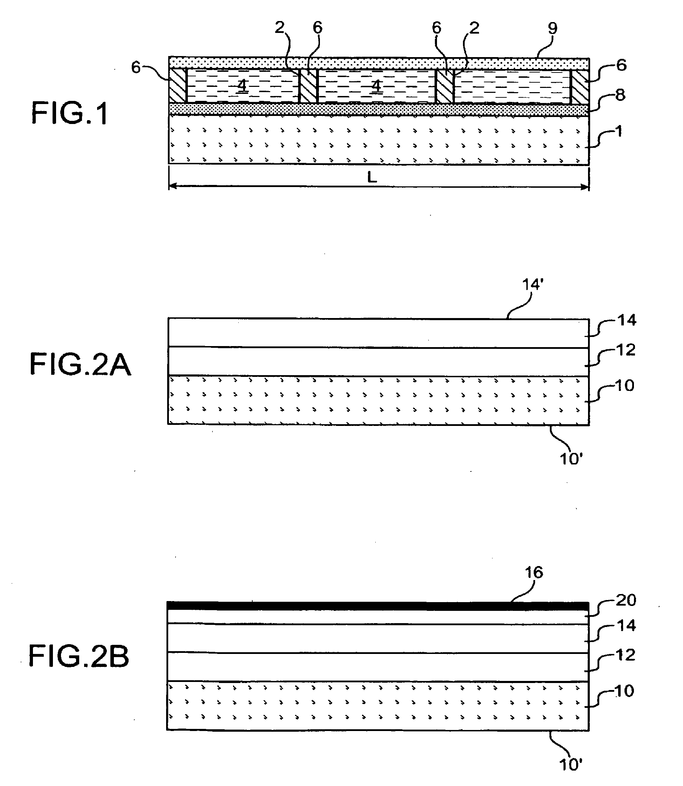

Un exemple d'un tel élément d'optique est illustré en figure 1. Il a une largeur L pouvant aller par exemple jusqu'à 100 mm ou plus.

Il comporte un réseau de micro-cuvettes ou de micro-cavités 2 indépendantes, séparées par des parois 6. Ces micro-cavités sont structurées sur un support sensiblement plan.

On peut ensuite les remplir avec un ou des liquides 4 appropriés à l'effet optique recherché.

Suivant les applications, les cavités peuvent être fermées par une couche de fermeture 9 en un matériau de préférence souple, en général collé sur les sommets des parois 6.

L'ensemble est formé sur un support comportant, dans l'exemple illustré, un substrat 1 en un matériau tel que le quartz et une couche 8 en un matériau polymère.

Un tel élément d'optique peut contenir un nombre de micro-cuvettes qui peut être de l'ordre de quelques dizaines de milliers voire quelques centaines de milliers et au-delà.

Pour les applications optiques les parois 6 doivent être les moins visibles possibles, ce qui impose un fort rapport d'aspect (ou facteur de forme), avec des largeurs de paroi faibles pour une hauteur importante dans la gamme souhaitée par exemple 2 à 100 µm.

Les parois, et les micro-cavités, peuvent être obtenues par un procédé de type micro-technologie collective, ou par gravure anisotrope d'une résine choisie pour ses propriétés structurales.

La technique dite de « embossing », ou moulage, permet de réaliser les facteurs de forme recherchés de manière très compétitive sur un plan économique, car c'est une opération directe.

Elle présente cependant l'inconvénient d'être très limitative sur la structure du fond de cuve car elle laisse par principe le même polymère que les murs, à moins de contrôler très précisément l'épaisseur du film moulé, ce qui reste très difficile.

Un autre procédé est la photolithographie d'une résine photosensible. On dépose une résine photosensible à l'épaisseur souhaitée et on l'insole avec une lumière UV afin de définir les parois.

Pour obtenir une bonne résolution avec cette technique, on doit utiliser des équipements de photolithographie onéreux. Néanmoins, ceux-ci, ne disposent pas de la profondeur de champ nécessaire à la réalisation de parois à fort rapport d'aspect. Cela entraîne la nécessité d'utiliser des techniques encore plus sophistiquées, ajoutant encore au coût de réalisation.

Deux problèmes sont à résoudre dans cette approche :
- le coût d'investissement élevé pour mettre en oeuvre une telle technique ; elle nécessite une machine optique qui, compte tenu de la résolution recherchée, doit être de type « stepper ». Le substrat est insolé en mode « step & repeat » : un masque, à l'échelle de l'élément d'optique, est insolé puis il y a déplacement du substrat pour insoler la zone suivante. Il s'ensuit une productivité ralentie d'autant plus que la résine photosensible est épaisse, peut être rendue opaque dans le visible par ajout d'un colorant noir et donc exiger des temps d'insolation long,
- la perte de résolution liée à l'épaisseur de la résine. En effet les optiques installées dans les machines optiques utilisées permettent d'atteindre une résolution de 2 µm (en réseau), mais sur des résines de 1 à 1,2 µm d'épaisseur. Or les murs des micro-cuvettes peuvent être de hauteur supérieure à 10 µm, il s'ensuit une perte de résolution qui peut interdire des traits d'une taille inférieure à 4 µm, donc être un frein à l'évolution des micro-cuvettes vers des tailles de plus en plus fines.

Il y a donc un problème à trouver un compromis adapté entre productivité et rapport de forme.

Enfin une autre technique utilisant le report direct, en face avant du support, des parois préalablement formées est difficile à mettre en oeuvre, car le contact entre les parois et le support est très délicat.

Il se pose donc le problème de trouver un procédé qui s'affranchisse de ces problèmes et permette de travailler sur une grande gamme d'épaisseur de matériau photosensible tout en ne sacrifiant pas la résolution et tout en permettant une bonne productivité.

Selon un autre aspect, il se pose le problème d'atteindre des rapports de formes plus faibles que celles obtenues avec les techniques classiques de photolithogravure.

Le document WO 02/065215 A2 divulgue un éclairage par la face arrière dans une méthode de production de micro cavités optiques.

Le document FR 2888948 divulgue des microcavités optiques.

### EXPOSÉ DE L'INVENTION

L'invention concerne principalement un procédé de formation de parois de cavités, pour la formation d'un dispositif optique ou micro-optique (micronique ou submicronique), comportant les étapes recitées dans la revendication 1.

Des modes de réalisation additionnels sont définis dans les revendications dépendantes.

L'invention permet de réaliser, en très grand nombre, des cavités ou micro-cavités dont les murs ont des facteurs de forme très variables et avec des matériaux photosensibles de toute polarité, chargés ou non en colorants. Elle permet également de garder une grande latitude dans le choix d'éventuelles sous couches faisant partie du support. Les cavités sou microcavités peuvent être destinées à contenir un fluide ou un liquide.

Ainsi, suivant les applications envisagées, le support peut comporter au moins une sous-couche en contact avec le fluide fonctionnel introduit dans les cavités et avec la base des parois. Cette sous-couche peut être choisie pour ses propriétés mécaniques (par exemple adhérence) et/ou électrique et/ou ses propriété de surface (par exemple suite à un traitement de surface approprié tel qu'un frottement et/ou un traitement hydrophile ou un traitement hydrophobe).

Ainsi, à titre d'exemple, on peut citer comme matériau utilisé pour former :
- une sous-couche d'adhérence : du SiO₂,
- une sous-couche d'actionnement électrique (électrode) : de l'ITO ou du WO3,
- une sous-couche d'alignement : un polyimide frotté.

Chacune de ces sous-couches peut être utilisée seule ou en combinaison avec une ou plusieurs autres de ces mêmes sous-couches et disposée entre le masque et le support.

Pour les applications optiques on choisira avantageusement un substrat transparent tel que du quartz, ou du plastique tel que du PET (Polyéthylène téréphtalate). Les sous-couches d'ITO, ou de SiO₂ ou de polyimide sont transparentes pour ces mêmes applications optiques. On obtient donc un dispositif dans lequel il y a transparence pour des rayonnements qui traversent le substrat de manière sensiblement perpendiculaire à celui-ci, ou qui traversent ou vont traverser la cavité délimitée par les parois formées. En particulier, il n'y a pas de portion de masque présente dans le fond des cavités. La gamme de rayonnement pour laquelle il y a transparence est de préférence comprise entre 260 nm et 450 nm.

Ainsi, le support peut comporter un simple substrat, ou un substrat et une ou plusieurs des sous couches supplémentaires ci-dessus.

L'invention met en oeuvre des moyens de photolithographie, pouvant être facilement intégrés dans un mode de réalisation collectif sur une même ligne de production.

Le masque de photolithogravure est de préférence un matériau absorbant aux UV et pouvant être éliminé, par exemple de manière chimique non agressive. Il est par exemple en chrome ou en Ti, et par exemple d'épaisseur d'environ quelques centaines de nm, par exemple encore environ 100 nm.

Les parois des cavités obtenues ont une épaisseur qui peut être comprise entre 2 µm et 100 µm et une largeur qui peut être comprise entre 10 µm et 0,5 µm.

Le matériau photosensible peut être une résine (déposée sous forme liquide puis polymérisée) ou un film sec (déposé par exemple par laminage).

Le matériau photosensible peut être rendu noir par l'ajout d'un colorant.

L'invention concerne également un procédé de formation d'un dispositif, utilisé pour la formation d'un dispositif optique ou micro-optique (micronique ou submicronique), comportant :
- la formation des parois de cavités de ce dispositif, comportant la mise en oeuvre d'un procédé tel qu'exposé ci-dessus,
- l'introduction d'un fluide dans les cavités du dispositif,
- la formation d'une couche de fermeture sur les parois en matériau photosensible.

Dans le cas d'une réalisation collective, une individualisation du produit final peut être effectuée.

### BRÈVE DESCRIPTION DES DESSINS

- La figure 1 représente une structure de cavité connue.
- Les figures 2A-2F représentent des étapes de réalisation d'un procédé selon l'invention.
- Les figures 3A-3C représentent certaines étapes de réalisation d'un autre procédé selon l'invention.
- La figure 4 représente une opération de remplissage de cavités avec un liquide, selon un mode de réalisation de l'invention.

### EXPOSÉ DÉTAILLÉ DE MODES DE RÉALISATION PARTICULIERS

Un mode de réalisation de l'invention va être décrit en liaison avec les figures 2A-2F.

On forme d'abord un support, qui peut consister en un simple substrat 10, par exemple en un matériau polymère tel que le PET.

En variante, sur la surface de ce même substrat 10, un ou plusieurs films 12, 14 transparents, en couche mince peuvent être déposés. Ces films déposés en couche mince sont par exemple un film 12 d'ITO de quelques centaines de nm d'épaisseur et un film 14 de polyimide (couche d'alignement) d'épaisseur comprise entre 30 nm et 100 nm d'épaisseur, frotté ou non à ce stade selon l'application visée.

L'ensemble forme un support, transparent aux rayonnements UV.

Le substrat 10 et les éventuelles couches 12, 14 sont de préférence transparents dans au moins la gamme spectrale 260 nm ~ 450 nm.

Par convention, la face, en principe libre, 14', côté empilement 12, 14, constitue la face dite « face avant » du support. S'il n'y a pas d'empilement 12, 14, mais seulement un substrat 10, l'une quelconque des faces est dite face avant. L'autre face 10' est dite « face arrière ».

Puis (figure 2B) une couche 16 de métal, par exemple une couche de chrome de 50 nm d'épaisseur, est déposée. Un métal différent du chrome peut être utilisé. On peut utiliser tout métal, ou même tout matériau absorbant aux UV (typiquement dans la gamme spectrale comprise entre 305 nm et 460 nm) et pouvant être éliminé sélectivement vis-à-vis du support, de la résine et des éventuelles sous-couches de frottement et/ou d'adhérence, et/ou autres. De préférence, l'élimination a lieu par une technique chimique. Par exemple, on peut utiliser une couche de Titane, qui peut être gravée ensuite au HF.

Une couche d'adhérence 20, par exemple en SiO₂ peut éventuellement être formée, avant dépôt de la couche 16. Cette couche 20 va permettre de renforcer l'adhérence de la future résine 18 sur le support. La couche 20 est elle aussi transparente, dans la même gamme de longueur d'ondes que les autres éléments (260 nm - 450 nm).

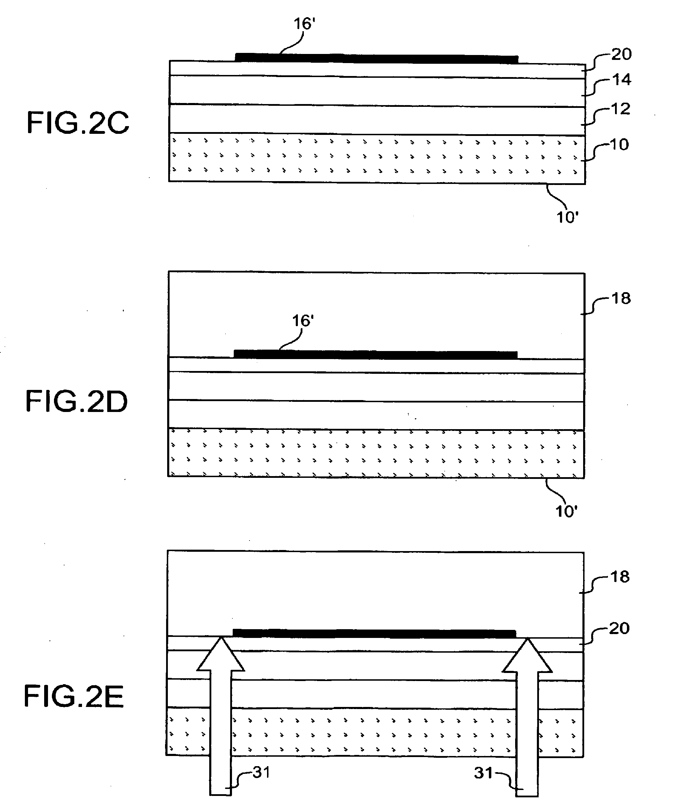

La couche de masquage (par exemple en métal) 16 peut ensuite être structurée, par exemple gravée pour délimiter la future forme des microcavités. A cette fin, on dépose sur la couche 16 un matériau photosensible par exemple une résine de photolithogravure. Celle-ci est insolée, à travers un masque approprié reproduisant la forme des motifs (en fait : la forme des murs des micro-cuvettes) que l'on souhaite réaliser ultérieurement. Cette résine de photolithogravure est développée, puis le matériau de la couche 16 est gravé par un bain acide (par exemple, gravure d'une couche 16 en Titane par du HF à 0,3 %); la résine non insolée, qui protège le matériau de la couche 16 là où on désire le garder, est alors retirée. On obtient donc un masque 16' (figure 2C).

Au cours de l'étape suivante (figure 2D), on dépose une résine épaisse 18 photosensible (épaisseur comprise entre 2 et 100 µm), de polarité négative, dans laquelle les murs des micro-cuvettes vont être réalisés. L'insolation de cette résine 18 est réalisée par la face arrière 10', à travers les ouvertures réalisées dans la couche de masquage UV 16. Ces murs seront formés à l'aide du masque précédemment réalisé qui protège, pour une insolation à partir de la face arrière 10', les zones où on souhaite par la suite éliminer la résine.

Puis (figure 2E), on procède à une insolation UV 31, par la face arrière 10' du support. Les zones de la résine qui sont insolées sont alors polymérisées et vont former les parois.

De préférence, on réalise l'insolation en un seul flash ou en scan, sur toute la surface du substrat. La source UV peut être de très haute énergie.

La résine est ensuite passée dans un développeur, qui va permettre de retirer les parties non insolées. Cette opération n'endommage pas l'éventuelle couche de polymère 14 qui, à cet endroit, est protégée par la couche de masquage. Le retrait de la couche de masquage UV, par gravure chimique, permet de retrouver la surface du support (ici : la surface du polymère 14) qui a pu être frottée préalablement au dépôt du masque et la couche d'alignement.

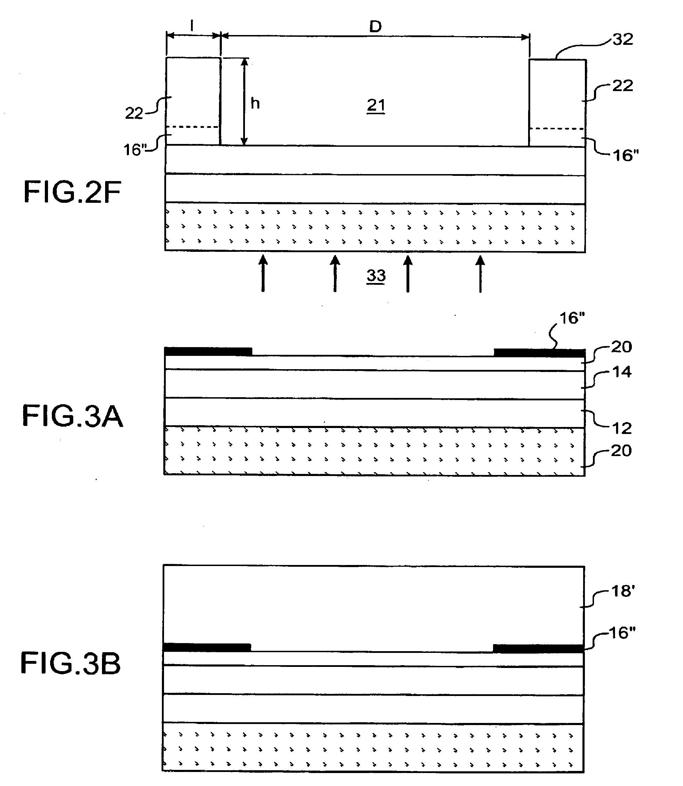

On obtient une structure comportant le support initial, la ou les éventuelle(s) sous couche(s) et les parois 22, de sommet 32, qui délimitent des cavités 21 (figure 2F). Une seule de ces cavités est représentée sur la figure 2F, mais le procédé peut être collectif et permet de réaliser plusieurs cavités, et même en très grand nombre.

La hauteur h des parois 22 qui délimitent chaque cavité 21 est typiquement de l'ordre de quelques µm ou de plusieurs dizaines de µm, par exemple de 20 µm et comprise entre 2 µm et 100 µm. La largeur l de chaque paroi peut être comprise entre 0,5 µm et 10 µm. Le facteur de forme est déterminé comme le rapport hauteur/largeur (rapport hauteur/largeur), il peut être compris entre, par exemple, 3 et 10. Chaque cavité 21 peut avoir une largeur ou un diamètre D moyen compris entre 10 µm et 500 µm.

On voit sur la figure 2F qu'un rayonnement 33 peut traverser le substrat de manière sensiblement perpendiculaire à celui-ci. En particulier, il n'y a pas de portion de masque ou d'un autre matériau, présente dans le fond des cavités ou dans l'empilement des couches 12, 14 et du substrat 2, et qui gênerait la propagation de ce rayonnement.

Un autre mode de réalisation de l'invention va être décrit en liaison avec les figures 3A-3C.

Les opérations mettent en oeuvre les mêmes matériaux que dans le mode de réalisation précédent, sauf pour la résine 18' (figure 3B) qui est cette fois une résine positive.

Les étapes sont donc sensiblement les mêmes que précédemment, sauf pour la réalisation du masque : on élimine le matériau de masque, par gravure, là où on souhaite éliminer la future résine 18' de photolithogravure, de polarité positive (figure 3A).

On dépose ensuite, après formation du masque (figure 3B), cette résine 18' de polarité positive, dans laquelle, là encore, les murs des micro-cuvettes vont être réalisés.

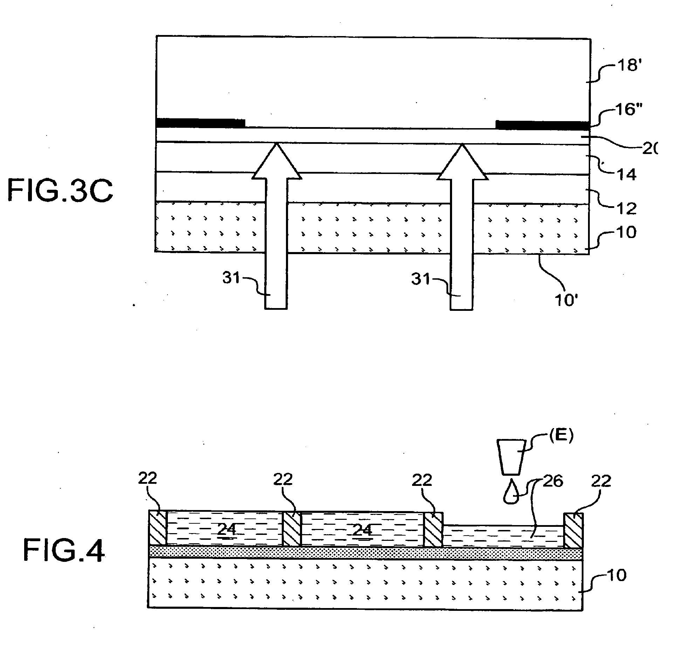

Puis (figure 3C) on procède à une insolation UV 31, par la face arrière 10' du support. Les zones de la résine qui sont insolées sont alors polymérisées. Là encore, de préférence, on réalise l'insolation en un seul flash, sur toute la surface du substrat. La source UV peut être de très haute énergie.

La résine est ensuite passée dans un développeur, qui va permettre de retirer les parties insolées. On se reportera aux remarques déjà faites ci-dessus pour cette étape.

Dans ce mode de réalisation, le masque 16" se retrouve alors sous le mur de résine qui est conservé et peut jouer par exemple le rôle de masque de contraste (« Black matrix ») ou permettre un actionnement électrique (cas par exemple d'un masque en ITO ou en WO3).

On obtient, là encore, la structure de la figure 2F, comportant le support initial et les parois 22, avec les caractéristiques -notamment géométriques-déjà décrites ci-dessus. En outre les zones de masque 16" sont situées sous les parois 22, mais pas entre les parois, dans les zones formant les cavités elles mêmes. Là encore, il n'y a pas de portion de masque ou d'un autre matériau, présente dans le fond des cavités ou dans l'empilement des couches 12, 14 et du substrat 2, et qui gênerait la propagation du rayonnement 33.

Quel que soit le mode de réalisation la résine épaisse 18, 18' de polarité positive ou négative peut être rendue noire par l'ajout d'un colorant. Le temps d'exposition augmente alors, mais est toujours acceptable, dans cette approche où une seule exposition en face arrière est réalisée.

Les micro-cavités ainsi formées ont pour objectif de retenir un fluide tel qu'un liquide ou des liquides qui peuvent être différents d'une cavité à l'autre, afin de réaliser une fonction optique spatialement définie.

Un liquide peut être un mélange de cristaux liquides, un liquide photosensible, ou tout autre liquide fonctionnel ou d'indice permettant de contrôler et modifier le trajet ou l'intensité des rayons optiques qui vont traverser le dispositif réalisé.

Dans le cas de liquides différents d'une cavité à l'autre, ces liquides peuvent être obtenus à partir du mélange de deux ou plusieurs liquides ou bien à partir de liquides tous différents. Ces liquides sont délivrés par toute technique adaptée à la localisation de faible volume, soit quelques dizaines à centaines de picolitres.

Notamment le remplissage d'une ou plusieurs cavités peut être réalisé par un équipement E (figure 4) visant l'intérieur des cavités 21 et projetant le matériau 24 liquide sous forme d'un jet ou de gouttes 26, d'un volume qui peut être de l'ordre de plusieurs picolitres. Le liquide peut être délivré à l'aide d'une technique adaptée à la localisation de faible volume, soit plusieurs dizaines à centaines de picolitres. L'équipement E utilisé peut mettre en oeuvre une technique de dispense de liquide semblable à celle de la dispense par jet d'encre.

Le matériau liquide 24 peut remplir les cavités 21 partiellement ou complètement. Un remplissage total des cavités peut être effectué de manière à atteindre le sommet 32 des parois 22.

Le produit est terminé par la formation, par exemple par laminage, d'un film plastique 9 protecteur (figure 1). Ce film peut être recouvert des couches fonctionnelles adaptées pour la fonction finale (antireflets, couches dures, antisalissures,...).

Selon une possibilité, pour certaines applications, par exemple pour la réalisation de lentilles optiques individuelles, une séparation entre elles des cavités 21 scellées, ou de groupes de cavités scellées, peut être effectuée. Les enceintes fermées remplies de liquide sont ainsi dissociées ou individualisées.

Une telle séparation peut être faite par exemple par laser, ou à l'aide d'ultrasons ou à l'aide d'au moins un outil tranchant, sur le support rigide 10 ayant servi à la réalisation du dispositif.

La séparation est réalisée après avoir assuré un scellement de la périphérie des cavités 21. Cette séparation peut s'accompagner d'un scellement périphérique qui assure l'étanchéité aux gaz et à l'humidité, et une bonne tenue mécanique sur la durée de vie du produit.

## Revendications

1. Procédé de formation d'un dispositif optique ou microoptique ou submicrooptique comportant des cavités (21) microniques ou submicroniques comportant des parois (22), comportant :
- la formation, sur un support transparent (10), d'un masque (16',16'') de photolithogravure,
- le dépôt d'une couche (18, 18') du matériau photosensible sur la face (14'), dite face avant, du support qui supporte le masque :
o si le matériau photosensible (18) est de polarité négative, les portions opaques du masque étant sous les zones où le matériau photosensible doit être éliminé,
o si le matériau photosensible (18') est de polarité positive, les portions opaques du masque étant sous les zones où le matériau photosensible doit être conservé et donc sans matériau de masque entre les parois ;
- l'insolation de la couche du matériau photosensible par la face arrière (10') du support,
- le développement du matériau photosensible pour obtenir lesdites parois et, si le matériau photosensible est de polarité négative, l'élimination des zones de masque situées au fond des cavités, pour obtenir des cavités sans matériau de masque entre les parois
- l'introduction d'un fluide (24, 26) dans les cavités (21) du dispositif optique ou microoptique ou submicrooptique, ce fluide permettant de réaliser une fonction optique dudit dispositif.

2. Procédé selon la revendication 1, comportant en outre au moins une sous-couche (20) disposée entre le masque et le support.

3. Procédé selon la revendication 2, ladite couche présentant des propriétés mécaniques et/ou électriques et/ou de surface.

4. Procédé selon la revendication 2 ou 3, au moins une sous-couche présentant des propriétés de surface (14) et étant en un polyimide.

5. Procédé selon l'une des revendications 2 à 4, au moins une sous-couche (12) présentant des propriétés électriques et étant en ITO ou en WO3.

6. Procédé selon l'une des revendications 2 à 5, au moins une sous-couche (12) présentant des propriétés mécaniques et étant en SiO₂.

7. Procédé selon l'une des revendications 1 à 6, le masque de photolithogravure étant en un matériau absorbant aux UV et pouvant être éliminé de manière chimique.

8. Procédé selon la revendication précédente, le masque (16', 16") étant en chrome ou en Titane.

9. Procédé selon l'une des revendications précédentes, les parois (22) ayant une épaisseur supérieure à 2 µm.

10. Procédé selon l'une des revendications précédentes, les parois ayant une largeur inférieure à 10 µm ou comprise entre 10 µm et 0,5 µm.

11. Procédé selon l'une des revendications précédentes, le matériau photosensible étant rendu noir par l'ajout d'un colorant.

12. Procédé selon l'une des revendications 1 à 11, dans lequel le support comprend un substrat transparent en un matériau choisi parmi du quartz ou du plastique.

13. Procédé selon l'une des revendications 1 à 12 comportant en outre la formation d'une couche (9) de fermeture sur les parois en matériau photosensible.

## Patentansprüche

1. Verfahren zur Bildung einer optischen oder mikrooptischen oder submikrooptischen Vorrichtung, welche Mikron- oder Submikron-Hohlräume (21) mit Wänden (22) aufweist, wobei das Verfahren die folgenden Schritte umfasst:
- die Bildung einer photolithographischen Maske (16', 16") auf einem transparenten Träger (10);
- die Ablage bzw. Aufbringung einer Schicht (18, 18') aus einem lichtempfindlichen Material auf der Seite (14'), der sogenannten Vorderseite, des die Maske tragenden Trägers, wobei:
o wenn das lichtempfindliche Material (18) negative Polarität aufweist, die lichtundurchlässigen Abschnitte der Maske unter den Bereichen liegen, wo das lichtempfindliche Material entfernt werden soll,
o wenn das lichtempfindliche Material (18') positive Polarität aufweist, die lichtundurchlässigen Abschnitte der Maske unter den Bereichen liegen, wo das lichtempfindliche Material erhalten werden soll, und sich folglich kein Maskenmaterial zwischen den Wänden befindet;
- die Isolierung der lichtempfindlichen Materialschicht durch die Rückseite (10') des Trägers;
- die Ausbildung bzw. Entwicklung des lichtempfindlichen Materials zum Erhalt der Wände, und, wenn das lichtempfindliche Material negative Polarität aufweist, Entfernung der Maskenbereiche, welche unten in den Hohlräumen angeordnet sind, um Hohlräume ohne Maskenmaterial zwischen den Wänden zu erhalten;
- die Einbringung eines funktionellen Fluids (24, 26) in die Hohlräume (21) der Vorrichtung, wobei das besagte funktionelle Fluid spezifische optische Eigenschaften aufweist, um die optische oder mikrooptische oder submikrooptische Vorrichtung zu realisieren.

2. Verfahren nach Anspruch 1, welches darüber hinaus mindestens eine Teilschicht (20) aufweist, welche zwischen der Maske und dem Träger angeordnet ist.

3. Verfahren nach Anspruch 2, wobei die besagte Schicht mechanische Eigenschaften und/oder elektrische Eigenschaften und/oder Oberflächeneigenschaften aufweist.

4. Verfahren nach Anspruch 2 oder 3, wobei zumindest eine Teilschicht Oberflächeneigenschaften (14) aufweist und aus einem Polyamid besteht.

5. Verfahren nach einem der Ansprüche 2 bis 4, wobei zumindest eine Teilschicht (12) elektrische Eigenschaften aufweist und aus ITO oder WO3 besteht.

6. Verfahren nach einem der Ansprüche 2 bis 5, wobei zumindest eine Teilschicht (12) mechanische Eigenschaften aufweist und aus SiO₂ besteht.

7. Verfahren nach einem der Ansprüche 1 bis 6, wobei die photolithographische Maske aus einem UV-absorbierendem Material besteht und chemisch beseitigt werden kann.

8. Verfahren nach dem vorhergehenden Anspruch, wobei die Maske (16', 16") aus Chrom oder Titan besteht.

9. Verfahren nach einem der vorhergehenden Ansprüche, wobei die Wände (22) eine Stärke von mehr als 2µm haben.

10. Verfahren nach einem der vorhergehenden Ansprüche, wobei die Wände eine Breite geringer als 10µm oder zwischen 10µm und 0,5µm aufweisen.

11. Verfahren nach einem der vorhergehenden Ansprüche, wobei das lichtempfindliche Material durch Zugabe eines Farbstoffs schwarz gemacht wird.

12. Verfahren nach einem der Ansprüche 1 bis 11, in welchem der Träger ein transparentes Substrat aus einem Material aufweist, welches aus Quarz oder Kunststoff ausgewählt wird.

13. Verfahren nach einem der Ansprüche 1 bis 12, welches des Weiteren den folgenden Schritt aufweist:
- die Bildung einer Abschluss- bzw. Deckschicht (9) auf den Wänden aus lichtempfindlichem Material.

## Claims

1. A method for forming an optical or micro-optical or sub-microoptical device comprising micron or submicron cavities (21) comprising walls (22), comprising:
- the formation of a photolithographic mask (16',16'') on a transparent support (10),
- the deposition of a layer (18, 18') of the photosensitive material on the face (14'), a so-called front face, of the support which supports the mask,
o if the photosensitive material (18) is of negative polarity, the opaque portions of the mask being under the areas where the photosensitive material should be removed,
o if the photosensitive material (18') is of positive polarity, the opaque portions of the mask being under the areas where the photosensitive material should be preserved and therefore without any mask material between the walls;
- the insolation of the layer of the photosensitive material through the rear face (10') of the support,
- the development of the photosensitive material in order to obtain said walls, and if the photosensitive material is of negative polarity, the removal of the mask areas located at the bottom of the cavities in order to obtain cavities without any mask material between the walls,
- the introduction of a fluid (24, 26) into the cavities (21) of the optical or micro-optical or sub-microoptical device, said fluid enabling an optical function of the fluid.

2. The method according to claim 1, further including at least one sublayer (20) between the mask and the support.

3. The method according to claim 2, said layer having mechanical and/or electrical and/or surface properties.

4. The method according to any of claims 2 or 3, at least one sublayer having surface properties (14) and being in polyimide.

5. The method according to any of claims 2 to 4, at least one sublayer (12) having electrical properties and being in ITO or in WO3.

6. The method according to any of claims 2 to 5, at least one sublayer (12) having mechanical properties and being in SiO₂.

7. The method according to any of claims 1 to 6, the photolithographic mask being in a UV-absorbent material and which may be removed chemically.

8. The method according to preceding claim, the mask (16', 16") being in chromium or in titanium.

9. The method according to any of the preceding claims, the walls (22) having a thickness of more than 2 µm.

10. The method according to any of the preceding claims, the walls having a width of less than 10 µm or comprised between 10 µm and 0.5 µm.

11. The method according to any of the preceding claims, the photosensitive material being blackened by adding a dye.

12. The method according to any of claims 1 to 11, wherein the support comprises a transparent substrate in a material selected from quartz or plastic.

13. A method according to any of claims 1 to 12, further comprising the formation of a closure layer (9) on the walls in photosensitive material.
